# EUROPEAN PATENT APPLICATION

(11) **EP 4 838 331 A1**
(43) Date of publication of application: **11.11.2026**
(21) Application number: 25816108.2
(22) Date of filing: 27.05.2025
(51) Int. Cl.: G06F 1/16, H05K 1/14

(54) **ELECTRONIC DEVICE INCLUDING CENTER BAR STRUCTURE**

(30) Priority: 27.05.2024 KR 20240068542; 31.07.2024 KR 20240102004
(71) Applicant: Samsung Electronics Co., Ltd., Suwon-si, Gyeonggi-do 16677 (KR)
(72) Inventor: LEE, Sangkyun, Suwon-si, Gyeonggi-do 16677 (KR); WOO, Jaehoon, Suwon-si, Gyeonggi-do 16677 (KR); LEE, Jongmin, Suwon-si, Gyeonggi-do 16677 (KR); CHO, Sehwan, Suwon-si, Gyeonggi-do 16677 (KR)
(74) Representative: Appleyard Lees IP LLP
(86) International application number: PCT/KR2025/007154
(87) International publication number: WO 2025/249867

(57) **Abstract**

According to an embodiment of the present disclosure, an electronic device may be provided. The electronic device may include: a housing including a first housing, a second housing, and a hinge cover; a flexible display disposed in the housing; a hinge assembly to which the first housing and the second housing are rotatably connected, the hinge assembly including a first support structure connected to the first housing and a second support structure connected to the second housing; a center bar structure at least partially disposed between the first support structure and the second support structure and spaced apart from the hinge cover; and a flexible circuit board disposed in the housing. The center bar structure may include: a support member including a first seating portion recessed toward the hinge cover; and a cover member disposed to cover at least a portion of the support member. The flexible circuit board may include: a first portion disposed in the first housing; a second portion disposed in the second housing; and a bending area extending between the first portion and the second portion. At least a portion of the bending area may be disposed between the first seating part and the cover member.

## Description

### [TECHNICAL FIELD]

The disclosure relates to an electronic device including a center bar structure.

### [BACKGROUND ART]

Due to advancement in information and communication technology and semiconductor technology, various functions are being integrated into a single portable electronic device. For example, an electronic device may implement not only communication functions, but also entertainment functions such as gaming, multimedia functions such as music/video playback, communication and security functions for mobile banking, or schedule management and electronic wallet functions. These electronic devices are being miniaturized to be conveniently carried by users.

The above-described information may be provided as related art for the purpose of helping understand the disclosure. No claim or determination is made as to whether any of the foregoing may be applied as prior art with respect to the disclosure.

### [DETAILED DESCRIPTION OF THE INVENTION]

### [TECHNICAL SOLUTION]

According to an aspect of the disclosure, an electronic device includes: a housing including a first housing, a second housing, and a hinge cover; a flexible display on the housing; a hinge assembly rotatably connected to the first housing and the second housing, wherein the hinge assembly includes a first support structure connected to the first housing and a second support structure connected to the second housing; a center bar structure at least partially between the first support structure and the second support structure and spaced apart from the hinge cover, wherein the center bar structure includes a support member including a first seating portion recessed toward the hinge cover and a cover member on at least a portion of the support member; and a flexible circuit board in the housing, wherein the flexible circuit board includes a first portion in the first housing, a second portion in the second housing, and a bending area extending between the first portion and the second portion, wherein at least a portion of the bending area is between the first seating portion of the support member and the cover member.

According to an embodiment of the disclosure, an electronic device includes: a housing including a first housing, and a second housing; a flexible display on the housing; a hinge assembly rotatably connected to the first housing and the second housing, the hinge assembly including a first support structure connected to the first housing and a second support structure connected to the second housing; a center bar structure at least partially between the first support structure and the second support structure, wherein the center bar structure includes a support member and a cover member fixed to the support member; and a flexible circuit board in the housing, wherein the flexible circuit board includes a bending area, wherein at least a portion of the bending area is between the support member and the cover member.

### [BRIEF DESCRIPTION OF DRAWINGS]

The above-described aspects or other features of certain embodiments of the disclosure will become more apparent through the following detailed description made with reference to the accompanying drawings, in which:
FIG. 1 is a block diagram of an electronic device according to one or more embodiments of the disclosure in a network environment;
FIG. 2A is a view illustrating an electronic device according to an embodiment of the disclosure in an unfolded state;
FIG. 2B is a view illustrating an electronic device according to an embodiment of the disclosure in an unfolded state;
FIG. 3 is a view illustrating the electronic device according to an embodiment of the disclosure in a folded state;
FIG. 4 is an exploded perspective view of an electronic device according to an embodiment of the disclosure;
FIG. 5A is a partial cross-sectional view of an electronic device illustrating a flexible circuit board and a center bar structure according to an embodiment of the disclosure;
FIG. 5B is an enlarged cross-sectional view illustrating the flexible circuit board and the center bar structure of the electronic device according to an embodiment of the disclosure;
FIG. 6 is a plan view of the center bar structure according to an embodiment of the disclosure;
FIG. 7A is a side view of the center bar structure according to an embodiment of the disclosure;
FIG. 7B is an exploded view of the center bar structure according to an embodiment of the disclosure;
FIG. 8 is a cross-sectional perspective view illustrating a part of the flexible circuit board and the center bar structure according to an embodiment of the disclosure;
FIG. 9 is a perspective view illustrating a hinge cover, a flexible circuit board, and a center bar structure in an unassembled state, according to an embodiment of the disclosure;
FIG. 10 is a perspective view illustrating a state in which a support member of the center bar structure is disposed on the flexible circuit board according to an embodiment of the disclosure;
FIG. 11 is a perspective view illustrating a state in which a cover member of the center bar structure is assembled to the flexible circuit board and the support member of FIG. 10, according to an embodiment of the disclosure;
FIG. 12A is a perspective view illustrating the flexible circuit board and the center bar structure according to an embodiment of the disclosure in an assembled state;
FIG. 12B is an enlarged perspective view of FIG. 12A according to an embodiment of the disclosure;
FIG. 13 is a perspective view illustrating a hinge cover, a center bar structure, and a flexible circuit board according to an embodiment of the disclosure;
FIG. 14 is a perspective view illustrating a hinge cover, a center bar structure, and a flexible circuit board according to an embodiment of the disclosure;
FIG. 15A is a perspective view illustrating a hinge cover, a center bar structure, and a flexible circuit board according to an embodiment of the disclosure;
FIG. 15B is an exploded perspective view illustrating a hinge cover, a center bar structure, and a flexible circuit board according to an embodiment of the disclosure;
FIG. 16A is a front perspective view of an electronic device in an unfolded state, according to an embodiment of the disclosure;
FIG. 16B is a rear perspective view of an electronic device in an unfolded state, according to an embodiment of the disclosure;
FIG. 16C is a perspective view of the electronic device in the folded state, according to an embodiment of the disclosure; and
FIG. 16D is a perspective view of the electronic device in the folded state, according to an embodiment of the disclosure.

Throughout the appended drawings, like reference numerals may be assigned to like components, configurations, and/or structures.

### [MODE FOR CARRYING OUT THE INVENTION]

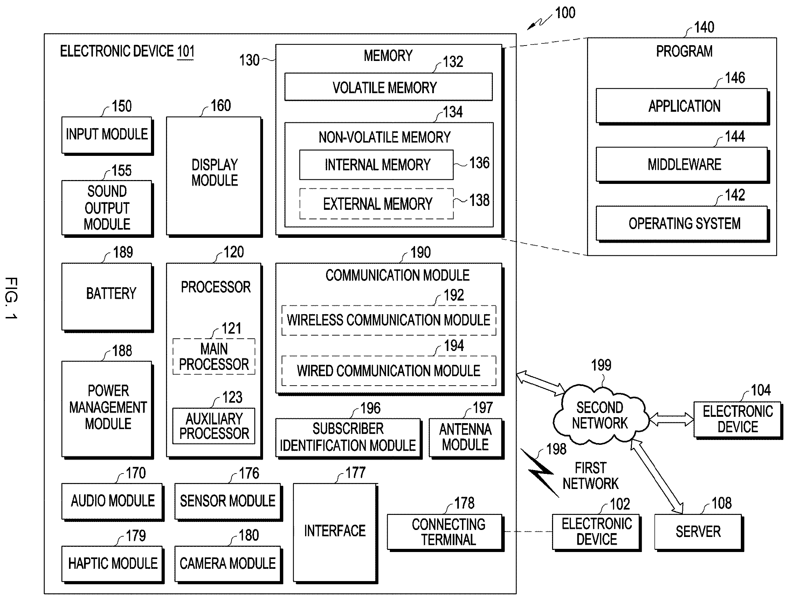

FIG. 1 is a block diagram illustrating an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

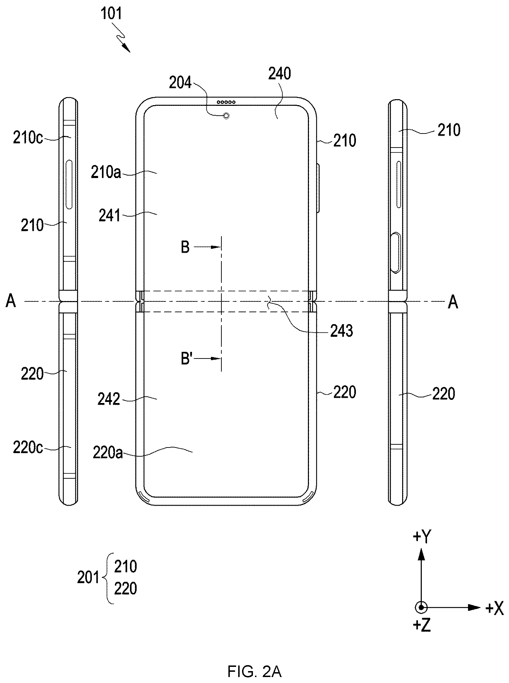

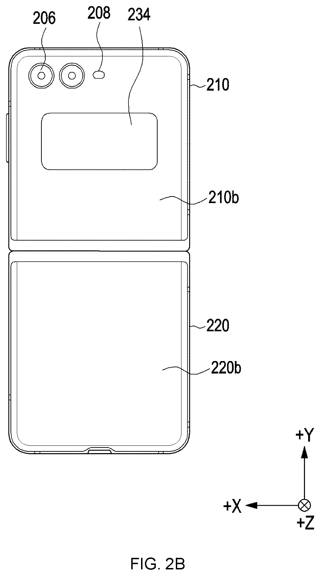

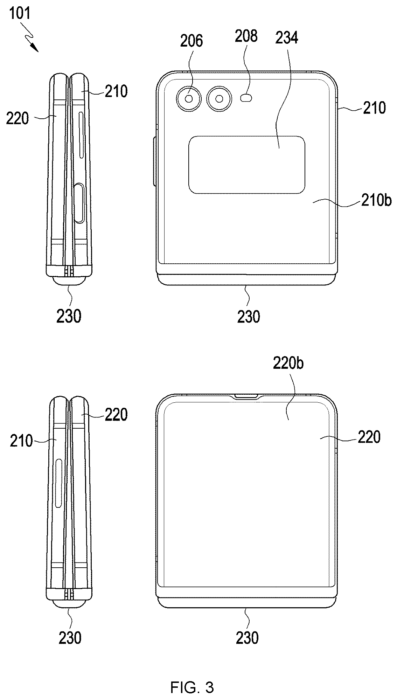

FIGS. 2A and 2B are views illustrating an electronic device according to an embodiment of the disclosure in an unfolded state. FIG. 3 is a view illustrating the electronic device according to an embodiment of the disclosure in a folded state.

The configuration of the electronic device 101 of FIGS. 2A to 3 may be partially or entirely identical to that of the electronic device 101 of FIG. 1.

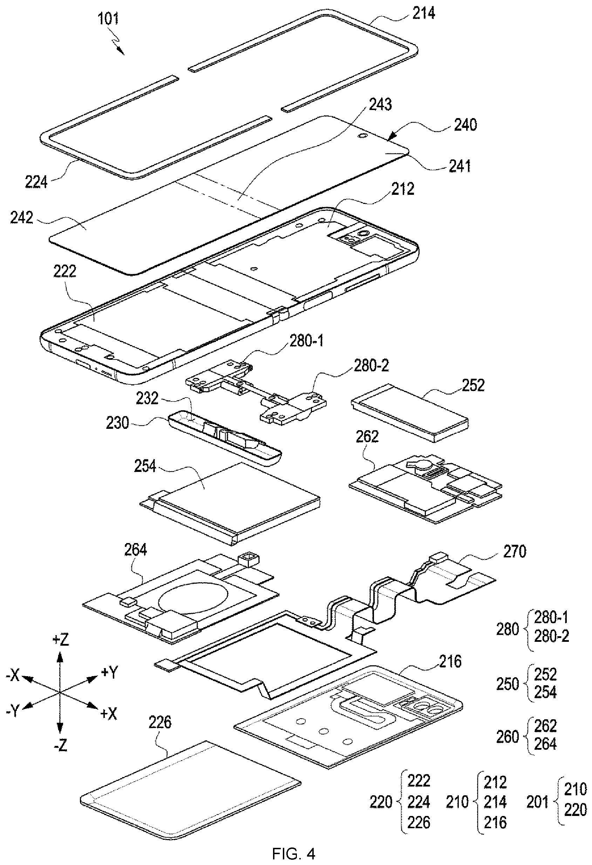

The embodiment of FIGS. 2A to 3 may be combined with the embodiment of FIG. 1 or the embodiments of FIGS. 4 to 16D, below.

In the detailed description below, the length direction of the electronic device 101 may be defined as the "Y-axis direction," the width direction may be defined as the "X-axis direction," and/or the height direction (thickness direction) may be defined as the "Z-axis direction." In the detailed description below, reference to the length direction, width direction, and/or height direction (or thickness direction) may indicate the length direction, width direction, and/or height direction (or thickness direction) of the electronic device 101. In one or more embodiments, with respect to the direction in which a component is oriented, "negative/positive (-/+)" may be mentioned along with the orthogonal coordinate system illustrated in the drawings. In FIGS. 2A to 3, an arrangement relationship in the height direction of a certain component or another component, that is, the criterion of above/below may be based on the +Z-axis direction/the -Z-axis direction, respectively.

Referring to FIGS. 2A to 3, the electronic device 101 may include a housing 201 configured to accommodate components of the electronic device 101 and a flexible display (hereinafter, referred to as a "display 240") disposed in a space defined by the housing 201. According to an embodiment, the housing 201 may be referred to as a "foldable housing." According to an embodiment, the display 240 may be referred to as a "foldable display." The electronic device 101 may also be referred to as a "foldable electronic device." The term "foldable electronic device" may refer to an electronic device in which two different areas of the display are foldable to face each other or to be oriented in opposite directions. In general, in a foldable electronic device while being carried, the display is folded in the state in which two different areas face each other or are oriented in opposite directions, and in actual use, a user may unfold the display such that the two different areas provide a substantially flat plate shape.

According to an embodiment, the housing 201 may include a first housing 210 and a second housing 220 configured to rotate relative to the first housing 210.

According to an embodiment, the first housing 210 and/or the second housing 220 may define at least a part of the exterior of the electronic device 101. According to an embodiment, the surface on which the display 240 is visually exposed may be defined as the front surface (e.g., a first front surface 210a and a second front surface 220a) of the electronic device 101 and/or the housing 201. The surface opposite to the front surface may be defined as the rear surface (e.g., a first rear surface 210b and a second rear surface 220b) of the electronic device 101. The surface surrounding at least a portion of the space between the front and rear surfaces may be defined as the side surface (e.g., a first side surface 210c and a second side surface 220c) of the electronic device 101.

According to an embodiment, the first housing 210 may be rotatably connected to the second housing 220 using a hinge assembly (e.g., the hinge assembly 280 in FIG. 4) including a hinge cover 230. For example, each of the first housing 210 and the second housing 220 may be rotatably connected to the hinge assembly (e.g., the hinge assembly 280 in FIG. 4). Accordingly, the electronic device 101 may transition to a folded state (e.g., FIG. 3) or an unfolded state (e.g., FIGS. 2A and 2B). When the electronic device 101 is in the folded state, the first front surface 210a may face the second front surface 220a, and when the electronic device 101 is in the unfolded state, the direction where the first front surface 210a is oriented may be substantially the same as the direction where the second front surface 220a is oriented. For example, in the unfolded state, the first front surface 210a may be located on substantially the same plane as the second front surface 220a. According to an embodiment, the second housing 220 may move relative to the first housing 210.

According to an embodiment, the first housing 210 and the second housing 220 may be disposed on opposite sides about the folding axis A and may have generally symmetrical shapes with respect to the folding axis A. The angle between the first housing 210 and the second housing 220 may change depending on whether the electronic device 101 is in the unfolded state, the folded state, or an intermediate state between the unfolded state and the folded state.

According to an embodiment, the electronic device 101 may include a hinge cover 230. At least a portion of the hinge cover 230 may be disposed between the first housing 210 and the second housing 220. According to an embodiment, depending on the state of the electronic device 101, the hinge cover 230 may be covered by portions of the first housing 210 and the second housing 220 or may be exposed to the outside of the electronic device 101. According to an embodiment, the hinge cover 230 may protect the hinge assembly (e.g., the hinge assembly 280 in FIG. 4) from external impact of the electronic device 101. According to an embodiment, the hinge cover 230 may be a hinge housing configured to protect the hinge assembly (e.g., the hinge assembly 280 in FIG. 4).

According to an embodiment, as illustrated in FIG. 2A and 2B, when the electronic device 101 is in the unfolded state, the hinge cover 230 may not be exposed by being covered by the first housing 210 and the second housing 220. As another example, as illustrated in FIG. 3, when the electronic device 101 is in the folded state (e.g., the fully folded state), the hinge cover 230 may be exposed to the outside between the first housing 210 and the second housing 220. As another example, when the first housing 210 and the second housing 220 are in the intermediate state in which the first and second housings are folded with a certain angle therebetween, the hinge cover 230 may be partially exposed to the outside between the first housing 210 and the second housing 220. However, the area exposed in this case may be smaller than that in the fully folded state. In an embodiment, the hinge cover 230 may include a curved surface.

According to an embodiment, the display 240 may visually provide information to the outside of the electronic device 101 (e.g., a user). The display 240 may include, for example, a hologram device or a projector, and a control circuit to control the corresponding device. According to an embodiment, the display 240 may include a touch sensor configured to detect a touch or a pressure sensor configured to measure the intensity of force generated by the touch.

According to an embodiment, the display 240 may refer to a display, at least a portion of which is transformable into a planar surface or a curved surface. For example, the display 240 may be configured to vary in response to the relative movement of the second housing 220 with respect to the first housing 210. According to an embodiment, the display 240 may include a folding area 243, and a first display area 241 disposed on one side (e.g., above (in the +Y direction)) of the folding area 243 and a second display area 242 disposed on the other side (e.g., below (in the -Y direction)) with respect to the folding area 243. According to an embodiment, the folding area 243 may be located above the hinge assembly (e.g., the hinge assembly 280 in FIG. 4). For example, at least a portion of the folding area 243 may face the hinge assembly (e.g., the hinge assembly 280 in FIG. 4). According to an embodiment, the first display area 241 may be disposed on the first housing 210, and the second display area 242 may be disposed on the second housing 220. According to an embodiment, the display 240 may be accommodated in the first housing 210 and the second housing 220.

However, the area division of the display 240 illustrated in FIGS. 2A and 2B is exemplary, and the display 240 may be divided into multiple (e.g., four or more or two) areas depending on its structure or function.

In addition, in the embodiment illustrated in FIGS. 2A and 2B, the areas of the display 240 may be divided by the folding area 243 or the folding axis (the axis A) extending in parallel to the X-axis. However, in another embodiment, the areas of the display 240 may be divided with reference to another folding area (e.g., a folding area parallel to the Y-axis) or another folding axis (e.g., a folding axis parallel to the Y-axis). According to an embodiment, the display 240 may be coupled to or disposed adjacent to a touch-sensitive circuit, a pressure sensor capable of measuring the intensity (pressure) of a touch, and/or a digitizer configured to detect an electromagnetic-field-type digital pen (a stylus pen).

According to an embodiment, the electronic device 101 may include a rear surface display 234. The rear display 234 may be disposed to be oriented in a different direction from the display 240. For example, the display 240 may be visually exposed through the front surface (e.g., the first front surface 210a and/or the second front surface 220a) of the electronic device 101, and the rear surface display 234 may be visually exposed through the rear surface (e.g., the first rear surface 210b) of the electronic device 101.

According to an embodiment, the electronic device 101 may include one or more camera modules 204 and 206 and a flash 208. According to an embodiment, the electronic device 101 may include a front camera module 204 exposed through the front surface (e.g., the first front surface 210a) and/or a rear camera module 206 exposed through the rear surface (e.g., the first rear surface 210b). The camera modules 204 and 206 may include one or more lenses, image sensors, flashes, and/or image signal processors. The flash 208 may include a light-emitting diode or xenon lamp. According to an embodiment, two or more lenses (e.g., an infrared camera lens, a wide-angle lens, and a telephoto lens) and image sensors may be disposed on one surface of the electronic device 101. The configuration of the front camera module 204 and/or the rear camera module 206 may be entirely or partially identical to the configuration of the camera module 180 of FIG. 1.

The electronic device 101 illustrated in FIGS. 2A to 3 has the appearance of a foldable electronic device, but the disclosure is not limited thereto. For example, the illustrated electronic device may be a part of a rollable electronic device, a bar-type electronic device, or a plate-type electronic device. The term "rollable electronic device" may mean an electronic device in which a display (e.g., the display 240 in FIGS. 2A and 2B) is transformable by bending thereby allowing the display to be at least partially wound or rolled or to be accommodated into a housing (e.g., the housing 210 in FIGS. 2A and 2B). According to a user's need, the rollable electronic device may be used in the state in which the screen display area is expanded by unfolding the display or exposing a larger area of the display to the outside.

FIG. 4 is an exploded perspective view of an electronic device according to an embodiment of the disclosure.

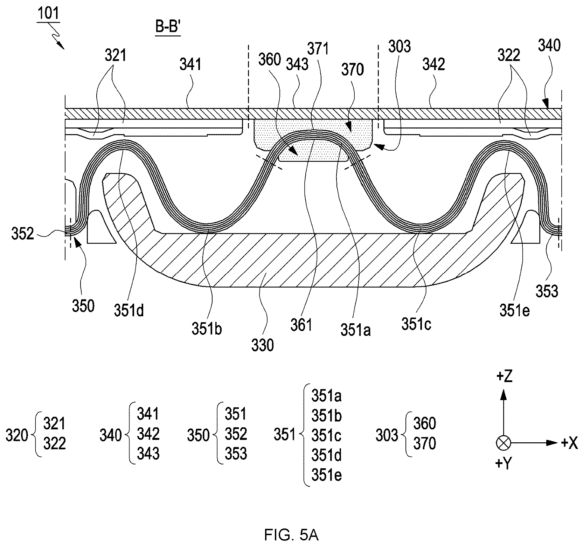

The embodiment of FIG. 4 may be combined with the embodiments of FIGS. 1 to 3 or the embodiments of FIGS. 5A to 8.

Referring to FIG. 4, the electronic device 101 may include a first housing 210, a second housing 220, a display 240, a hinge cover 230, a battery 250, a printed circuit board 260, a flexible printed circuit board 270, and a hinge assembly 280. The configurations of the first housing 210, the second housing 220, the display 240, and the hinge cover 230 of FIG. 4 may be entirely or partially identical to those of the first housing 210, the second housing 220, the display 240, and the hinge cover 230 of FIG. 2 and/or FIG. 3.

According to an embodiment, the electronic device 101 may include a first support structure 212 and a second support structure 222. For example, the first housing 210 may include a first support structure 212, and the second housing 220 may include a second support structure 222. According to an embodiment, the first support structure 212 and/or the second support structure 222 may support components of the electronic device 101 (e.g., the display 240, the battery 250, and the printed circuit board 260).

According to an embodiment, the first support structure 212 and/or the second support structure 222 may be made of a metal material and/or a non-metal (e.g., polymer) material. According to an embodiment, the first support structure 212 may be disposed between the display 240 and the battery 250. For example, the display 240 may be coupled to one surface of the first support structure 212, and the battery 250 and the printed circuit board 260 may be disposed on the other surface.

According to an embodiment, the electronic device 101 may include a first protective member 214 and a second protective member 224. For example, the first housing 210 may include the first protective member 214, and the second housing 220 may include the second protective member 224. According to an embodiment, the protective members 214 and 224 may protect the display 240 from external impacts. For example, the first protective member 214 may surround at least a portion of one portion of the display 240 (e.g., the first display area 241 in FIG. 2A), and the second protective member 224 may surround at least a portion of another portion of the display 240 (e.g., the second display area 242 in FIG. 2A). According to an embodiment, the first protective member 214 may be referred to as a "first cover member," and the second protective member 224 may be referred to as a "second cover member."

According to an embodiment, the housings 210 and 220 may include a first rear surface plate 216 and a second rear surface plate 226. For example, the first housing 210 may include a first rear surface plate 216 connected to the first support structure 212, and the second housing 220 may include a second rear surface plate 226 connected to the second support structure 222. According to an embodiment, the rear surface plates 216 and 226 may define a portion of the exterior of the electronic device 101. For example, the first rear surface plate 216 may define the first rear surface (e.g., the first rear surface 210b in FIGS. 2 and 3), and the second rear surface plate 226 may define the second rear surface (e.g., the second rear surface 220b in FIG. 2 and 3). According to an embodiment, a first battery 252 and a first printed circuit board 262 may be disposed between the first support structure 212 and the first rear surface plate 216, and a second battery 254 and a second printed circuit board 264 may be disposed between the second support structure 222 and the second rear surface plate 226.

According to an embodiment, the hinge cover 230 may accommodate at least a portion of the hinge assembly 280. For example, the hinge cover 230 may include an accommodation groove 232 to accommodate the hinge assembly 280. According to an embodiment, the hinge cover 230 may be coupled with the hinge assembly 280. According to an embodiment, when the electronic device 101 is in the unfolded state, at least a portion of the hinge cover 230 may be positioned between the hinge assembly 280 and the housings 210 and 220.

According to an embodiment, the battery 250 is a device that supplies power to at least one component of the electronic device 101, and may include a non-rechargeable primary battery, a rechargeable secondary battery, or a fuel cell. The battery 250 may be integrally disposed inside the electronic device 101 or may be detachably disposed on the electronic device 101. According to an embodiment, the battery 250 may include a first battery 252 disposed in the first housing 210 and a second battery 254 disposed in the second housing 220. For example, the first battery 252 may be disposed on the first support structure 212, and the second battery 254 may be disposed on the second support structure 222.

According to an embodiment, a processor (e.g., the processor 120 in FIG. 1), memory (e.g., the memory 130 in FIG. 1), and/or an interface (e.g., the interface 177 in FIG. 1) may be mounted on the printed circuit board 260. According to an embodiment, the printed circuit board 260 may include a first printed circuit board 262 disposed in the first housing 210 and a second printed circuit board 264 disposed in the second housing 220.

According to an embodiment, the flexible printed circuit board 270 may electrically connect a component positioned in the first housing 210 (e.g., the first printed circuit board 262) and a component positioned in the second housing 220 (e.g., the second printed circuit board 264). According to an embodiment, the flexible printed circuit board 270 may be a flexible printed circuit board (FPCB). According to an embodiment, at least a portion of the flexible printed circuit board 270 may extend across the hinge cover 230 and/or the hinge assembly 280. For example, a portion of the flexible printed circuit board 270 may be disposed within the first housing 210 and another portion may be disposed within the second housing 220. According to an embodiment, the flexible printed circuit board 270 may be connected to an antenna or the display 240. According to an embodiment, the flexible printed circuit board 270 may be configured such that at least a portion thereof is bendable.

According to an embodiment, the hinge assembly 280 may be connected to the first housing 210 and the second housing 220. According to an embodiment, the first housing 210 may rotate relative to the second housing 220 using the hinge assembly 280. According to an embodiment, the hinge assembly 280 may interconnect the first housing 210 and the second housing 220 to be rotatable from the folded state (e.g., FIG. 3) to the unfolded state (e.g., FIGS. 2A and 2B).

According to an embodiment, the hinge assembly 280 may include multiple hinge assemblies 280-1 and 280-2 arranged in parallel to each other. For example, the hinge assembly 280 may include a first hinge assembly 280-1 and a second hinge assembly 280-2 spaced apart from the first hinge assembly 280-1. According to an embodiment, the first hinge assembly 280-1 and the second hinge assembly 280-2 may be symmetrical to each other with respect to the length direction of the electronic device 101 (e.g., the Y-axis direction).

The electronic device 101 illustrated in FIGS. 2A to 4 has the appearance of a foldable electronic device, but the disclosure is not limited thereto. For example, the illustrated electronic device may be a bar-type electronic device, a plate-type electronic device, or a rollable electronic device. The term "rollable electronic device" may mean an electronic device in which a display (e.g., the display 240 in FIG. 4) is transformable by bending thereby allowing the display to be at least partially wound or rolled or to be accommodated into a housing (e.g., the housing 201 in FIG. 2A). According to a user's need, the rollable electronic device may be used in the state in which the screen display area is expanded by unfolding the display or exposing a larger area of the display to the outside.

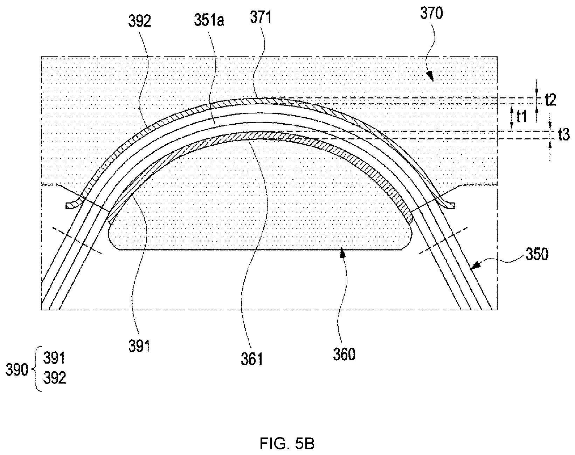

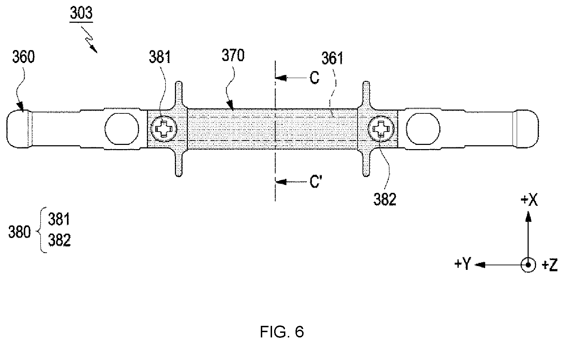

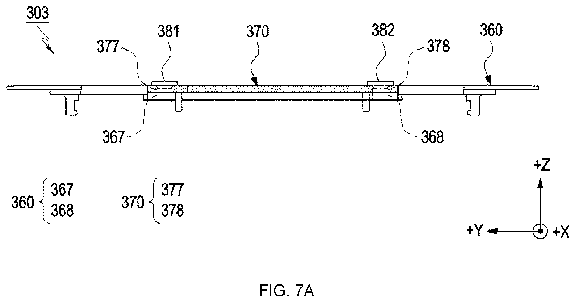

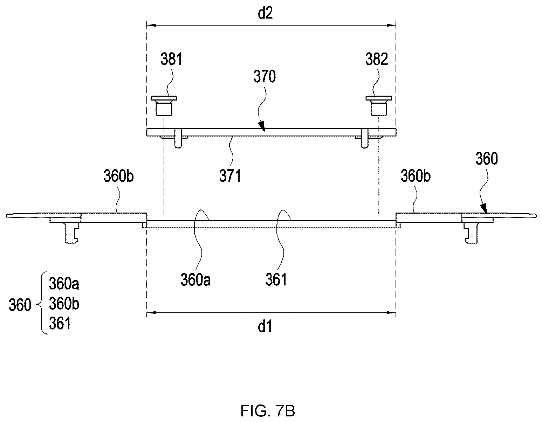

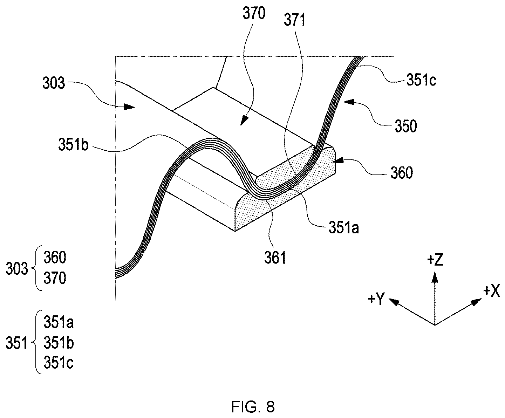

FIG. 5A is a partial cross-sectional view of an electronic device illustrating a flexible circuit board and a center bar structure according to an embodiment of the disclosure. FIG. 5B is an enlarged cross-sectional view illustrating the flexible circuit board and the center bar structure of the electronic device according to an embodiment of the disclosure. FIG. 6 is a plan view of the center bar structure according to an embodiment of the disclosure. FIG. 7A is a side view of the center bar structure according to an embodiment of the disclosure. FIG. 7B is an exploded view of the center bar structure according to an embodiment of the disclosure. FIG. 8 is a cross-sectional perspective view illustrating a part of the flexible circuit board and the center bar structure according to an embodiment of the disclosure.

FIG. 5A may be a cross-sectional view taken along line B-B' of FIG. 2A. FIG. 8 may be a cross-sectional view taken along line C-C' of FIG. 6, and in FIG. 8, the flexible circuit board may be illustrated together with the center bar structure of FIG. 6. The configuration of the electronic device 101 in FIG. 5A may be wholly or partially identical to or similar to the configuration of the electronic device 101 in FIGS. 1 to 4.

Referring to FIGS. 5A to 8, according to an embodiment, the electronic device 101 (e.g., the electronic device 101 in FIGS. 1 to 5A) may include a housing (e.g., the housing 201 in FIGS. 2A to 4), a flexible display 340 (e.g., the display 240 in FIGS. 2A to 4), a center bar structure 303 (also referred to as a center plate or a center bar assembly), and a flexible circuit board 350 (e.g., the flexible printed circuit board 270 in FIG. 4). According to embodiments of the disclosure, the center bar structure 303 of the electronic device 101 may shape at least a portion of the flexible circuit board 350 within the housing 201 and may prevent interference between the flexible display 340 and the flexible circuit board 350.

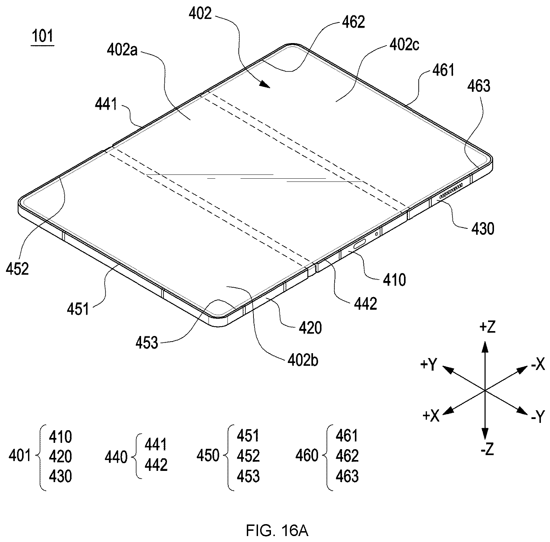

According to an embodiment, the housing 201 may include a first housing (e.g., the first housing 210 in FIGS. 2A to 4), a second housing (e.g., the second housing 220 in FIGS. 2A to 4) rotatably connected to the first housing 210, and a hinge cover 330 (e.g., the hinge cover 230 in FIGS. 3 and 4) at least partially disposed between the first housing 210 and the second housing 220. According to an embodiment, a hinge assembly (e.g., the hinge assembly 280 in FIG. 4) that rotatably connects the first housing 210 and the second housing 220 may be disposed in the space between the hinge cover 330 and the flexible display 340. According to an embodiment of the disclosure (see, e.g., FIGS. 5A to 12B), the electronic device 101 may include a single hinge assembly (e.g., the hinge assembly 280 in FIG. 4) and a single center bar structure 303. However, the disclosure is not limited thereto, and according to an embodiment (see, e.g., FIGS. 16A to 16D), the electronic device 101 may include multiple hinge assemblies and center bar structures 303.

According to an embodiment, the electronic device 101 or the hinge assembly (e.g., the hinge assembly 280 in FIG. 4) may further include a support member 320 connected to the housing 201 to assist in the rotation of the electronic device 101. For example, the support member 320 may be configured to support the flexible display 340. According to an embodiment, the support member 320 may include a first support structure 321 connected to the first housing 210 and a second support structure 322 connected to the second housing 220. For example, the support member 320 may be bonded or coupled to the rear surface (e.g., the surface in the -Z direction) of the flexible display 340. For example, the first support structure 321 may be disposed to face the first display area 341, and the second support structure 322 may be disposed to face the second display area 342. According to an embodiment, the first support structure 321 and the second support structure 322 may be spaced apart from each other with the center bar structure 303 interposed therebetween.

According to an embodiment, the flexible circuit board 350 may include a bending area 351, a first portion 352 disposed on one side of the bending area 351, and a second portion 353 disposed on the other side of the bending area 351. For example, the bending area 351 may refer to an area of the flexible circuit board 350, which is variable while bending or unfolding in response to the rotation of the second housing (e.g., the second housing 220 in FIGS. 2A to 4) relative to the first housing (e.g., the first housing 210 in FIGS. 2A to 4). According to an embodiment, the first portion 352 of the flexible circuit board 350 may be electrically connected to a first circuit board (e.g., the first printed circuit board 262 in FIG. 4) disposed in the first housing (e.g., the first housing 210 in FIGS. 2A to 4), and the second portion 353 may be electrically connected to a second circuit board (e.g., the second printed circuit board 264 in FIG. 4) disposed in the second housing (e.g., the second housing 220 in FIGS. 2A to 4). According to an embodiment, the bending area 351 of the flexible circuit board 350 may include a first bending area 351a supported by the center bar structure 303, a second bending area 351b and a third bending area 351c disposed on opposite sides of the first bending area 351a, a fourth bending area 351d extending between the second bending area 351b and the second portion 353, and a fifth bending area 351e extending between the third bending area 351c and the second portion 353. For example, in the unfolded state of the electronic device 101, as illustrated in FIG. 5A, the second bending area 351b and the third bending area 351c may bend in a direction different from, for example, opposite to, the bending direction of the first bending area 351a.

For example, the first portion 352 of the flexible circuit board 350 may be disposed within the first housing (e.g., the first housing 210 in FIGS. 2A to 4), and may be coupled or fixed to the first housing 210 or to a structure and/or an electrical component within the first housing 210. For example, the second portion 353 of the flexible circuit board 350 may be disposed within the second housing (e.g., the second housing 220 in FIGS. 2A to 4), and may be coupled or fixed to the second housing 220 or to a structure and/or an electrical component within the second housing 220.

According to an embodiment, the center bar structure 303 may be configured to support the bending area 351 (e.g., the first bending area 351a) of the flexible circuit board 350 and to maintain the flexible circuit board 350 in place (e.g., at a designed position) within a space. According to an embodiment, the center bar structure 303 may be disposed between the flexible display 340 and the hinge cover 330. According to an embodiment, at least a portion of the center bar structure 303 may be disposed between the first support structure 321 and the second support structure 322. In the disclosure, shaping the flexible circuit board 350 may refer to supporting or fixing at least a portion of the flexible circuit board 350 so that its central portion remains at a designed position without being affected by the repetitive folding operations of the foldable (or multi-foldable) electronic device 101.

According to an embodiment, the center bar structure 303 may include a support member 360 and a cover member 370 configured to support the bending area 351 (e.g., the first bending area 351a) of the flexible circuit board 350. The support member 360 may be disposed to face the cover member 370 with at least a portion of the bending area 351 (e.g., the first bending area 351a) of the flexible circuit board 350 interposed therebetween. According to an embodiment, the cover member 370 may be disposed between the support member 360 and the flexible display 340. According to an embodiment, the support member 360 may be located closer to the hinge cover 330 than the cover member 370, while the cover member 370 may be located closer to the flexible display 340 than the support member 360. According to an embodiment, the support member 360 and the cover member 370 may be arranged such that their centers are aligned with the center of the hinge cover 330 and/or the flexible display 340 in the thickness direction of the electronic device 101 (e.g., the Z-axis direction). For example, the support member 360 and the cover member 370 may be respectively in contact with opposite surfaces of the first bending area 351a. In other words, the support member and the cover member may support the first bending area 351a in the up-down direction (e.g., the Z-axis direction). According to an embodiment, the support member 360 and the cover member 370 may serve to shape the flexible circuit board 350 within the electronic device 101, preventing the flexible circuit board 350, which is arranged to extend across the electronic device 101 in the left-right direction (e.g., the X-axis direction) (see, e.g., FIG. 4), from deviating or shifting to the left (e.g., in the -X direction) or to the right (e.g., in the +X direction) from its designed position.

Referring to FIGS. 5A and 8, according to an embodiment, the support member 360 may include a first seating portion 361 where a portion of the bending area 351 (e.g., the first bending area 351a) of the flexible circuit board 350 is disposed. According to an embodiment, the first seating portion 361 may include a curved surface either entirely or partially. According to an embodiment, the cover member 370 may include a second seating portion 371 that is in contact with the first bending area 351a of the flexible circuit board 350. The second seating portion 371 may be disposed to face the first seating portion 361 of the support member 360 with the first bending area 351a interposed therebetween. According to an embodiment, the second seating portion 371 may include a curved surface either entirely or partially.

According to an embodiment, the first seating portion 361 of the support member 360 may include a convex surface which is convex toward the direction in which the flexible display 340 or the cover member 370 is disposed or toward the bending area 351. The curved surface of the first seating portion 361 may protrude in the thickness direction of the electronic device 101 (the Z-axis direction) and may extend in the longitudinal direction of the center bar structure 303 (or the longitudinal direction of the electronic device 101) (e.g., the Y-axis direction).

According to an embodiment, the second seating portion 371 of the cover member 370 may include a concave surface which is concave toward the direction in which the support member 360 is disposed or toward the bending area 351. The curved surface of the second seating portion 371 may be recessed in the thickness direction of the electronic device 101 (the Z-axis direction) and may extend in the longitudinal direction of the center bar structure 303 (or the longitudinal direction of the electronic device 101) (e.g., the Y-axis direction).

According to an embodiment, the curvature of the convex surface of the first seating portion 361 may be the same as or similar to the curvature of the concave surface of the second seating portion 371. For example, at least a portion of the shape of the first seating portion 361 may be configured to correspond to or to be engaged with the shape of the second seating portion 371. According to an embodiment, the curvature of the curved surface of the first seating portion 361 may be different from the curvature of the curved surface of the second seating portion 371. According to an embodiment, the curvature of the concave surface of the second seating portion 371 may be smaller than the curvature of the convex surface of the first seating portion 361. However, the curvatures of the first seating portion 361 and the second seating portion 371 are not limited and may be modified based on factors such as the thickness or arrangement of the flexible circuit board 350. As one example, the curvature of the first seating portion 361 may be smaller than that of the second seating portion 371.

Referring to FIG. 5B, according to an embodiment, the center bar structure 303 may further include a buffer member 390. The buffer member 390 may be disposed on a surface of the support member 360 and/or the cover member 370 that is in contact with a portion of the bending area 351 (e.g., the first bending area 351a) of the flexible circuit board 350. According to an embodiment, the buffer member 390 may include a first buffer member 391 and/or a second buffer member 392. According to an embodiment, the first buffer member 391 may be disposed between the first seating portion 361 of the support member 360 and at least a portion of the bending area 351 (e.g., the first bending area 351a). According to an embodiment, the second buffer member 392 may be disposed between the cover member 370 and at least a portion of the bending area 351 (e.g., the first bending area 351a) of the flexible circuit board 350. For example, the buffer member 390 may be configured to absorb at least a part of the stress transmitted to the bending area 351 (e.g., the first bending area 351a) through the support member 360 and/or the cover member 370, thereby preventing or reducing damage to the bending area 351 (e.g., the first bending area 351a). According to an embodiment, the first buffer member 391 may have a stiffness lower than that of the first seating portion 361 of the support member 360. According to an embodiment, the second buffer member 392 may have a stiffness lower than that of the cover member 370 and, preferably, lower than that of the second seating portion 371. Referring to FIG. 5B, according to an embodiment, the thickness t1 of the bending area 351 (e.g., the first bending area 351a) may be greater than the thickness t2 of the first buffer member 391 and the thickness t3 of the second buffer member 392.

Referring to FIG. 7B, according to an embodiment, the support member 360 may include a first area 360a and a second area 360b, which form the first seating portion 361. According to an embodiment, the second area 360b may be stepped from the first area 360a, and the first seating portion 361 may have a recessed shape that is concave toward the hinge cover 330. According to an embodiment, the stepped structure between the first area 360a and the second area 360b may provide a space in which the flexible circuit board 350 may be placed or seated in the first seating portion 361. For example, in a state in which the flexible circuit board 350 is assembled in the first seating portion 361, at least a portion of the flexible circuit board 350 (e.g., the first bending area 351a) may be disposed between portions of the second area 360b.

Referring to FIG. 7B, according to an embodiment, based on the width measured in a first direction (e.g., the Y-axis direction in FIG. 7A) intersecting the longitudinal direction of the flexible circuit board 350 (e.g., the first bending area 351a), the width d2 of the cover member 370 may be greater than the width d1 of the first seating portion 361 of the support member 360.

In an embodiment, the center bar structure 303 may further include a fixing member 380 configured to fix the cover member 370 to the support member 360. According to an embodiment, the fixing member 380 may include a first fixing member 381 and a second fixing member 382 positioned at opposite ends of the cover member 370.

In an embodiment, the cover member 370 may include a first opening 377 and a second opening 378, which are respectively provided at opposite ends of the cover member 370. The first fixing member 381 may pass through the first opening 377, and the second fixing member 382 may pass through the second opening 378. For example, the first fixing member 381 and the second fixing member 382 may be respectively fixed to opposite ends of the support member 360 with the first seating portion 361 of the support member 360 interposed therebetween. For example, the first bending area 351a may be disposed to pass between the first fixing member 381 and the second fixing member 382.

According to an embodiment, the support member 360 may include a first fastening hole 367 provided at a position corresponding to (or overlapping) the first opening 377 configured to accommodate the first fixing member 381 and a second fastening hole 368 formed at a position corresponding to (or overlapping) the second opening 378 configured to accommodate the second fixing member 382. According to an embodiment, the first fastening hole 367 and the second fastening hole 368 may have a recessed shape or may be omitted. For example, the first fixing member 381 may be disposed from the first fastening hole 367 to the first opening 377, and the second fixing member 382 may be disposed from the second fastening hole 368 to the second opening 378. For example, the first fixing member 381 and the second fixing member 382 may or may not include threads on their outer surfaces.

In the disclosure, the number and shape of the fixing members 380 are not limited. For example, the fixing member 380 may be configured with a single component or three or more components. In the disclosure, means for connecting the cover member 370 to the support member 360 is not limited, and depending on the embodiment, the fixing member 380 may be omitted. As an example, the support member 360 and the cover member 370 may further include a fastening structure configured to engage with each other and may be directly coupled by the fastening structure. Alternatively, regardless of the presence of the fixing member 380, additional or alternative coupling means (e.g., double-sided tape, adhesive, or welding) may be used to couple the components together.

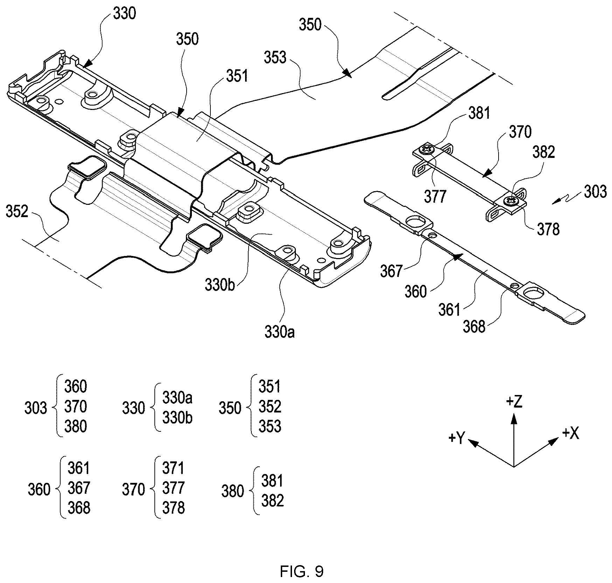

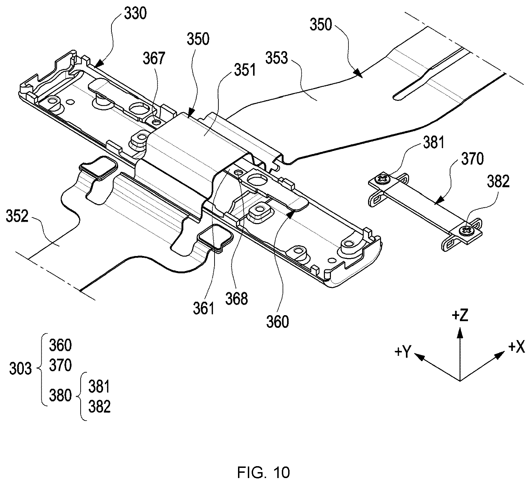

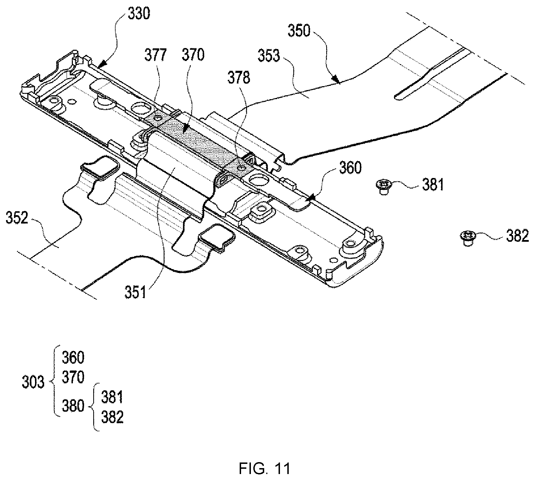

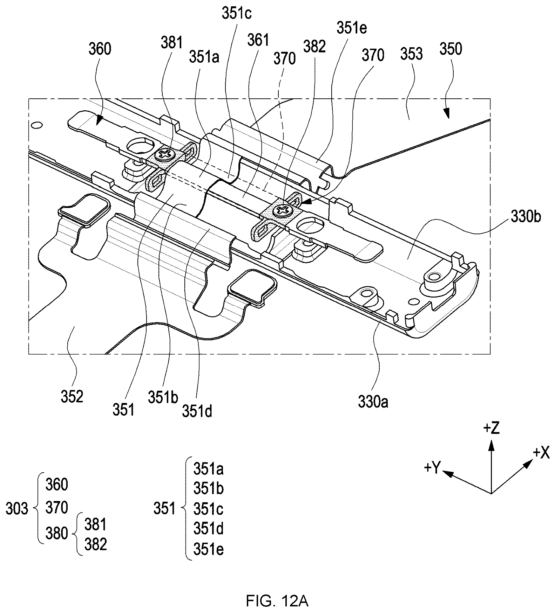

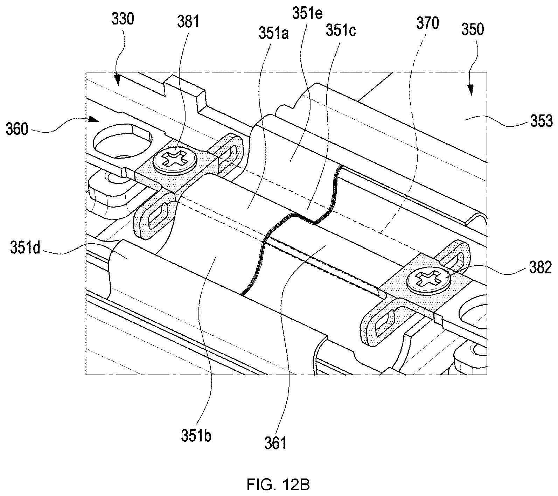

FIG. 9 is a perspective view illustrating a hinge cover, a flexible circuit board, and a center bar structure in an unassembled state, according to an embodiment of the disclosure. FIG. 10 is a perspective view illustrating a state in which a support member of the center bar structure is disposed on the flexible circuit board according to an embodiment of the disclosure. FIG. 11 is a perspective view illustrating a state in which a cover member of the center bar structure is assembled to the flexible circuit board and the support member of FIG. 10, according to an embodiment of the disclosure. FIG. 12A is a perspective view illustrating the flexible circuit board and the center bar structure according to an embodiment of the disclosure in an assembled state. FIG. 12B is an enlarged perspective view of FIG. 12A according to an embodiment of the disclosure.

FIGS. 9 to 11 may illustrate the process of assembling the support member 360, the cover member 370, and the fixing member 380 of the center bar structure 303 to the flexible circuit board 350, as described with reference to FIGS. 5A to 8. FIGS. 12A and 12B may illustrate the assembled state of the center bar structure 303, as described with reference to FIGS. 5A to 8, in which a portion of the flexible circuit board 350 and a portion of the cover member 370 are omitted to describe the state in which a portion of the bending area 351 (e.g., the first bending area 351a in FIG. 5A) of the flexible circuit board 350 is disposed on the first seating portion 361 of the support member 360.

Referring to FIGS. 9 and 10, according to an embodiment, the support member 360 of the center bar structure 303 may be disposed between a portion of the bending area 351 of the flexible circuit board 350 (e.g., the first bending area 351a in FIG. 5A) and the hinge cover 330. For example, the support member 360 may be arranged such that the first seating portion 361 faces the rear surface (e.g., the surface in the -Z direction) of the bending area 351 (e.g., the first bending area 351a in FIG. 5A) or the surface facing the hinge cover 330. For example, when the support member 360 includes fastening holes (e.g., the first fastening hole 367 and the second fastening hole 368), the bending area 351 (e.g., the first bending area 351a in FIG. 5A) may be positioned between the fastening holes (e.g., the first fastening hole 367 and the second fastening hole 368).

FIG. 11 illustrates a state in which the cover member 370 is placed on the support member 360 with the flexible circuit board 350 interposed therebetween, according to an embodiment, in which the fixing member 380 may be illustrated in a state before being assembled to the support member 360 and the cover member 370. The cover member 370 may be arranged such that the second seating portion (e.g., the second seating portion 371 in FIGS. 5A and 8) is in contact with a portion of the bending area 351 (e.g., the first bending area 351a in FIG. 5A) of the flexible circuit board 350. In the state in which the cover member 370 is assembled to the support member 360, the openings of the cover member 370 (e.g., the first opening 377 and the second opening 378) may respectively correspond to, overlap, or face the fastening holes of the support member 360 (e.g., the first fastening hole 367 and the second fastening hole 368).

FIGS. 12A and 12B may illustrate a state in which the fixing member 380 of FIG. 11 is completely assembled to the support member 360 and the cover member 370, according to an embodiment. FIGS. 12A and 12B may illustrate a state in which the center bar structure 303, as described with reference to FIGS. 5A to 8, is fully assembled, and a portion of the bending area 351 (e.g., the first bending area 351a in FIG. 5A) of the flexible circuit board 350 is disposed on the first seating portion 361 of the support member 360. For example, FIGS. 12A and 12B may illustrate a state in which at least a portion of the bending area 351 of the flexible circuit board 350 and a portion of the cover member 370 are omitted.

Referring to FIGS. 12A and 12B, according to an embodiment, the first bending area 351a of the flexible circuit board 350 may be disposed in a bent state while being in contact with the curved surface of the first seating portion 361 of the support member 360 (see FIGS. 5A and 8). For example, the lengths of the second bending area 351b and the third bending area 351c of the flexible circuit board 350 may include a margin for expansion when the electronic device 101 (see FIG. 3) is in the unfolded state, compared to when the electronic device 101 (see FIGS. 2A and 2B) is in the folded state. FIGS. 9 to 12B may illustrate the components of the electronic device 101, including the flexible circuit board 350 and the center bar structure 303, in the unfolded state of the electronic device 101 (see FIGS. 2A and 2B).

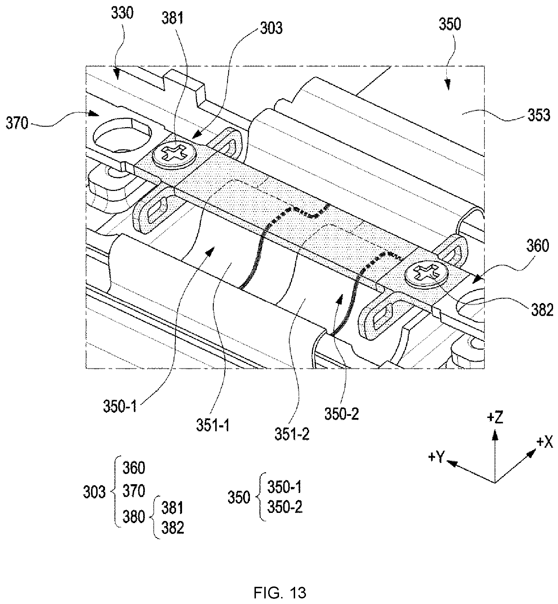

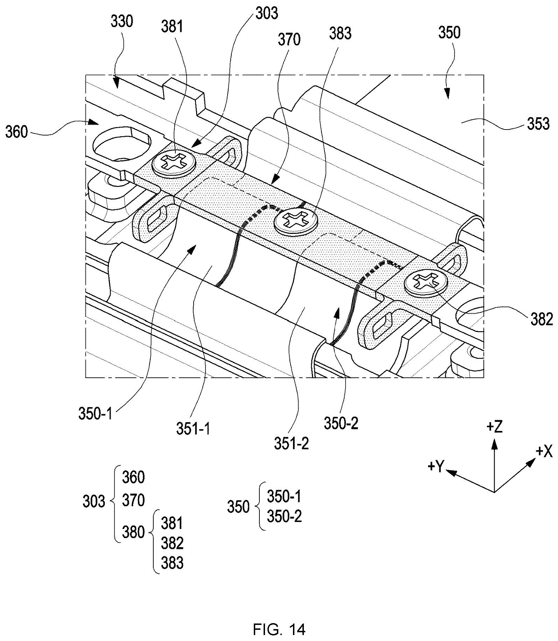

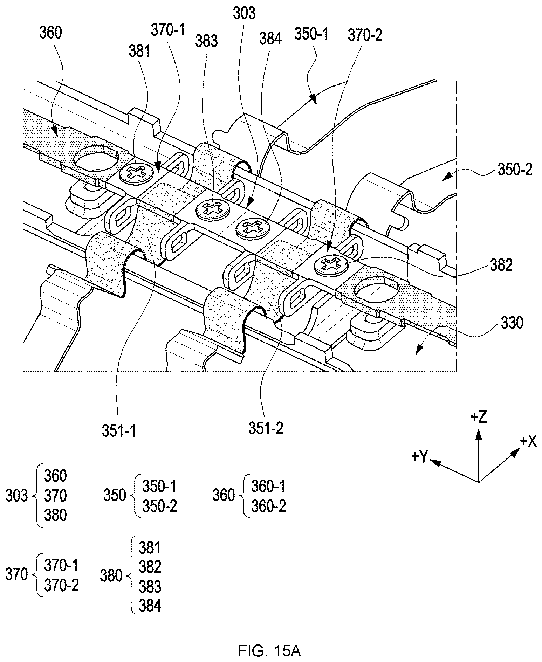

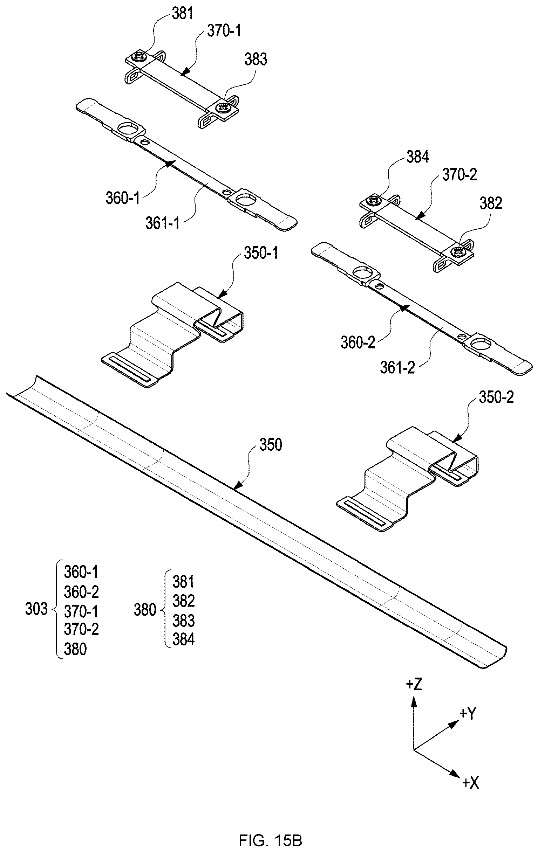

FIG. 13 is a perspective view illustrating a hinge cover, a center bar structure, and a flexible circuit board according to an embodiment of the disclosure. FIG. 14 is a perspective view illustrating a hinge cover, a center bar structure, and a flexible circuit board according to an embodiment of the disclosure. FIG. 15A is a perspective view illustrating a hinge cover, a center bar structure, and a flexible circuit board according to an embodiment of the disclosure. FIG. 15B is an exploded perspective view illustrating a hinge cover, a center bar structure, and a flexible circuit board according to an embodiment of the disclosure.

Referring to FIGS. 13, 14, 15A, and 15B, according to an embodiment, the flexible circuit board 350 may include a first flexible circuit board 350-1 and a second flexible circuit board 350-2, which are spaced apart from each other. According to an embodiment, the first flexible circuit board 350-1 and the second flexible circuit board 350-2 in the embodiments of FIGS. 13, 14, 15A, and 15B may be separate flexible circuit boards. According to an embodiment, the first flexible circuit board 350-1 and the second flexible circuit board 350-2 may be portions where the bending area 351 of a single flexible circuit board 350 is divided into two branches. In this case, for example, portions other than the bending areas 351-1 and 351-2 (e.g., the second portions 353-1 and 353-2) of the first flexible circuit board 350-1 and the second flexible circuit board 350-2 may be connected to each other or integrated. According to an embodiment (see FIGS. 13, 14, and 15A), the first flexible circuit board 350-1 and the second flexible circuit board 350-2 may be connected to a single center bar structure 303. According to an embodiment (see FIG. 15B), the first flexible circuit board 350-1 and the second flexible circuit board 350-2 may be connected to a single center bar structure 303 or may be connected to separate center bar structures 303. The first bending area 351-1 of the first flexible circuit board 350-1 and the second bending area 351-1 of the second flexible circuit board 350-2 may be supported by the support member 360 and the cover member 370.

Referring to FIG. 13, according to an embodiment, the first flexible circuit board 350-1 and the second flexible circuit board 350-2 may be disposed on the first seating portion (e.g., the first seating portion 361 in FIG. 12A) of a single support member 360. According to an embodiment, the cover member 370 may be disposed over the first flexible circuit board 350-1 and the second flexible circuit board 350-2.

Referring to FIG. 14, according to an embodiment, the first seating portion (e.g., the first seating portion 361 in FIG. 12A) of the support member 360 may include a 1-1 seating portion (also referred to herein as a first seating region), on which the first flexible circuit board 350-1 is disposed, and a 1-2 seating portion (also referred to herein as a second seating region), which is spaced apart from the first seating region, and on which the second flexible circuit board 350-2 is disposed. According to an embodiment, the cover member 370 may be disposed over the first flexible circuit board 350-1 and the second flexible circuit board 350-2. According to an embodiment, the cover member 370 may be disposed over the first flexible circuit board 350-1 and the second flexible circuit board 350-2. According to an embodiment, the cover member 370 may further include one or more additional openings provided between the area on which the first flexible circuit board 350-1 is disposed and the area where the second flexible circuit board 350-2 is disposed. According to an embodiment, the center bar structure 303 may further include an additional fixing member (or third fixing member) 383, which is configured to pass through the one or more additional openings and fix the cover member 370 to the support member 360. According to an embodiment, the third fixing member 383 may be disposed between the first flexible circuit board 350-1 and the second flexible circuit board 350-2.

Referring to FIG. 15A, according to an embodiment, the cover member 370 may include a first cover member 370-1 disposed over the first flexible circuit board 350-1 and a second cover member 370-2 disposed over the second flexible circuit board 350-2. Referring to FIG. 15A, as an example, the first flexible circuit board 350-1 and the second flexible circuit board 350-2 may be disposed on the first seating portion 361 of a single support member 360. As an example, the first seating portion 361 of the support member 360 may include a 1-1 seating portion on (also referred to herein as a first seating region) which the first flexible circuit board 350-1 is disposed and a 1-2 seating portion (also referred to herein as a second seating region), which is spaced apart from the first seating region, and on which the second flexible circuit board 350-2 is disposed. According to an embodiment, the fixing member 380 may further include a third fixing member 383 and a fourth fixing member 384, which are disposed between the first flexible circuit board 350-1 and the second flexible circuit board 350-2.

Referring to FIG. 15B, according to an embodiment, the center bar structure 303 may include a first center bar structure 303-1 and a second center bar structure 303-2, which is separated from the first center bar structure 303-1. The first center bar structure 303-1 and the second center bar structure 303-2 may be spaced apart from each other in the longitudinal direction of the hinge cover 330 (e.g., the Y-axis direction). For example, the first center bar structure 303-1 may include a first support member 360-1 configured to support a portion of the first flexible circuit board 350-1, a first cover member 370-1, a first fixing member 381, and a third fixing member 383. For example, the second center bar structure 303-2 may include a second support member 360-2 configured to support a portion of the second flexible circuit board 350-2, a second cover member 370-2, a second fixing member 382, and a fourth fixing member 384.

The center bar structure 303 of the embodiments described with reference to FIGS. 5A to 15B may also be applied to an electronic device 101 that performs a folding operation about multiple parallel rotation axes (e.g., two rotation axes), such as the electronic device 101 according to the embodiment of FIGS. 16A to 16D (e.g., a multi-foldable electronic device). According to an embodiment, the electronic device 101 according to the embodiment described later with reference to FIGS. 16A to 16D may include multiple center bar structures 303 corresponding to a first hinge 470 and a second hinge 480, and the descriptions provided with reference to FIGS. 5A to 15B may be identically or similarly applied to the multiple center bar structures 303.

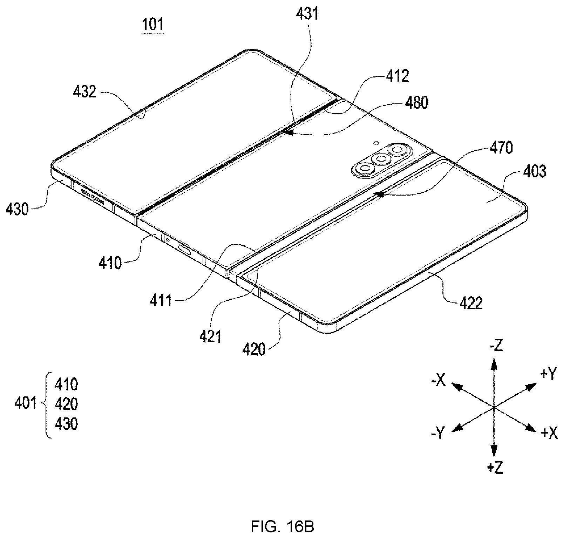

FIG. 16A is a front perspective view of an electronic device in an unfolded state, according to an embodiment of the disclosure. FIG. 16B is a rear perspective view of an electronic device in an unfolded state, according to an embodiment of the disclosure. FIG. 16A may be a perspective view obliquely illustrating one surface (e.g., the front surface) of the electronic device 101 in an unfolded state (e.g., a first state), according to an embodiment, and FIG. 16B may be a perspective view obliquely illustrating the other surface (e.g., the rear surface) of the electronic device 101 in an unfolded state, according to an embodiment. The components illustrated in FIGS. 16A and 16B may be partially or entirely identical to the components described with reference to FIGS. 1 to 4.

Referring to FIGS. 16A and 16B, according to an embodiment, the electronic device 101 may include a housing 401. The electronic device 101 may include a first display 402. The housing 401 may provide a space in which the first display 402 is disposed. The first display 402 may be a flexible display disposed on the front surface of the housing 401. At least a portion of the first display 402 may be foldable or unfoldable. Here, the front surface may be configured to be oriented in the +Z direction when the electronic device 101 is in the unfolded state, as illustrated in FIG. 16A. For example, the first surface may be the surface where the first housing 410 and the second housing 420 face each other when the second housing 420 transitions from an unfolded state to a folded state (rotating from the +X direction to the -X direction). Here, the folded state may include a completely folded state and a slightly open state (e.g., a state where the main display, the first display 402, is opened by less than a predetermined angle at which it remains inactive). According to an embodiment, the housing 401 may include a first housing 410 having a first surface (e.g., a front surface) and a second surface (e.g., a rear surface), and a second housing 420 rotatably connected to the first housing 410 and having a third surface (e.g., a front surface) and a fourth surface (e.g., a rear surface). According to an embodiment, the housing 401 of the electronic device 101 may be configured in a multi-foldable structure further including a third housing 430 rotatably connected to the first housing 410 and having a fifth surface (e.g., a front surface) and a sixth surface (e.g., a rear surface). The disclosure is not limited thereto, and the housing 401 of the electronic device 101 may be configured as a multi-foldable structure including four or more housings.

The first housing 410 may be disposed between the second housing 420 and the third housing 430. The second housing 420 may be rotatably coupled to the first housing 410. The third housing 430 may be rotatably coupled to the first housing 410. The first display 402 may include a first display area 402a configured to have a size similar to or identical to that of the front surface (e.g., the first surface) of the first housing 410, a second display area 402b configured to have a size similar to or identical to that of the front surface (e.g., the third surface) of the second housing 420, and a third display area 402c configured to have a size similar to or identical to that of the front surface (e.g., the fifth surface) of the third housing 430.

According to an embodiment, the electronic device 101 may include supports 440, 450, and 460. The supports 440, 450, and 460 may be disposed between the housing 401 and the first display 402. The supports 440, 450, and 460 may be coupled to the housing 401 and may support the first display 402. The supports 440, 450, and 460 may be arranged to surround the edges of the first display 402. The supports 440, 450, and 460 may extend along the perimeter of the housing 401. The supports 440, 450, and 460 may include a first support 440 disposed in the first housing 410, a second support 450 disposed in the second housing 420, and a third support 460 disposed in the third housing 430. The supports 440, 450, and 460 may be referred to as a "body." The supports 440, 450, and 460 may be referred to as a "frame." The supports 440, 450, and 460 may be referred to as a "sealing member." The supports 440, 450, and 460 may be referred to as a "peripheral part." The supports 440, 450, and 460 may be referred to as a "circumferential part." The supports 440, 450, and 460 may be referred to as a "peripheral structure." The supports 440, 450, and 460 may be referred to as a "circumferential structure."

According to an embodiment, the supports 440, 450, and 460 may include the first support 440. The first support 440 may be disposed between the first housing 410 and the first display 402. The first support 440 may be disposed along the edge of the first housing 410. The first support 440 may include a (1-1)^{th} support 441 and a (1-2)^{th} support 442. At least a portion of the first display 402 may be disposed between the (1-1)^{th} support 441 and the (1-2)^{th} support 442. The (1-1)^{th} support 441 may be disposed at one end portion of the first housing 410, and the (1-2)^{th} support 442 may be disposed at the other end portion of the first housing 410. Each of the supports 440, 450, and 460 may be referred to as a "support." The supports 440, 450, and 460 may include a non-conductive member. The supports 440, 450, and 460 may be referred to as a "decoration," a "finishing member," or a "non-conductive member."

According to an embodiment, the supports 440, 450, and 460 may include a second support 450. The second support 450 may be disposed between the second housing 420 and the first display 402. The second support 450 may be disposed along an edge of the second housing 420. The second support 450 may include a (2-1)^{th} support 451, a (2-2)^{th} support 452, and a (2-3)^{th} support 453. At least a portion of the first display 402 may be disposed between the (2-2)^{th} support 452 and the (2-3)^{th} support 453. The (2-1)^{th} support 451 may connect the (2-2)^{th} support 452 and the (2-3)^{th} support 453. The (2-1)^{th} support 451 may extend along an edge (e.g., the (2-2)^{th} side portion 422 or the third surface in FIG. 16B) of the second housing 420. The (2-1)^{th} support 451 may be disposed between the (2-2)^{th} side portion 422 of the second housing 420 and the first display 402. The (2-1)^{th} support 451 may be referred to as a "support frame" or a "first support frame." The (2-2)^{th} support 452 and the (2-3)^{th} support 453 may each be referred to as a "second support frame."

According to an embodiment, the supports 440, 450, and 460 may include a third support 460. The third support 460 may be disposed between the third housing 430 and the first display 402. The third support 460 may be disposed along an edge of the third housing 430. The third support 460 may include a (3-1)^{th} support 461, a (3-2)^{th} support 462, and a (3-3)^{th} support 463. At least a portion of the first display 402 may be disposed between the (3-2)^{th} support 462 and the (3-3)^{th} support 463. The (3-1)^{th} support 461 may connect the (3-2)^{th} support 462 and the (3-3)^{th} support 463. The (3-1)^{th} support 461 may extend along an edge (e.g., the (3-2)^{th} side portion 432 in FIG. 3) of the third housing 430. The (3-1)^{th} support 461 may be disposed between the (3-3)^{th} side portion 432 of the third housing 430 and the first display 402. The (3-1)^{th} support 461 may be referred to as a "support frame" or a "first support frame." The (3-2)^{th} support 462 and the (3-3)^{th} support 463 may each be referred to as a "second support frame."

According to an embodiment, the first housing 410 may include a (1-1)^{th} side portion 411 and a (1-2)^{th} side portion 412. Each of the (1-1)^{th} side portion 411 and the (1-2)^{th} side portion 412 may form opposite sides of the first housing 410. The second housing 420 may be coupled to the (1-1)^{th} side portion 411. The third housing 430 may be coupled to the (1-2)^{th} side portion 412. The (1-1)^{th} side portion 411 may be referred to as a "first coupling portion." The (1-2)^{th} side portion 412 may be referred to as a "second coupling portion." The (1-1)^{th} side portion 411 may be referred to as a "first portion." The (1-2)^{th} side portion 412 may be referred to as a "second portion."

According to an embodiment, the second housing 420 may include a (2-1)^{th} side portion 421 and a (2-2)^{th} side portion 422 (e.g., a third surface). Each of the (2-1)^{th} side portion 421 and the (2-2)^{th} side portion 422 may define opposite sides of the second housing 420. The (2-1)^{th} side portion 421 may be coupled to the first housing 410. The (2-2)^{th} side portion 422 may define a side surface of the housing 401. The (2-2)^{th} side portion 422 may be referred to as an "edge." The (2-1)^{th} side portion 421 may be referred to as a "third side portion." The (2-2)^{th} side portion 422 may be referred to as a "fourth side portion."

According to an embodiment, the third housing 430 may include a (3-1)^{th} side portion 431 and a (3-2)^{th} side portion 432. Each of the (3-1)^{th} side portion 431 and the (3-2)^{th} side portion 432 may define opposite sides of the third housing 430. The (3-1)^{th} side portion 431 may be coupled to the first housing 410. The (3-2)^{th} side portion 432 may define a side surface of the housing 401. The (3-2)^{th} side portion 432 may be referred to as an "edge." The (3-1)^{th} side portion 431 may be referred to as a "fifth side portion." The (3-2)^{th} side portion 432 may be referred to as a "sixth side portion."

According to an embodiment, the electronic device 101 may include a first hinge 470 and a second hinge 480. The first hinge 470 may be disposed between the first housing 410 and the second housing 420. The first hinge 470 may be disposed between the (1-1)^{th} side portion 411 and the (2-1)^{th} side portion 421. The first hinge 470 may rotatably connect the first housing 410 and the second housing 420. The second hinge 480 may be disposed between the first housing 410 and the third housing 430. The second hinge 480 may be disposed between the (1-2)^{th} side portion 412 and the (3-1)^{th} side portion 431. The second hinge 480 may rotatably connect the first housing 410 and the third housing 430. The first hinge 470 may be referred to as a "first hinge member." The second hinge 480 may be referred to as a "second hinge member."

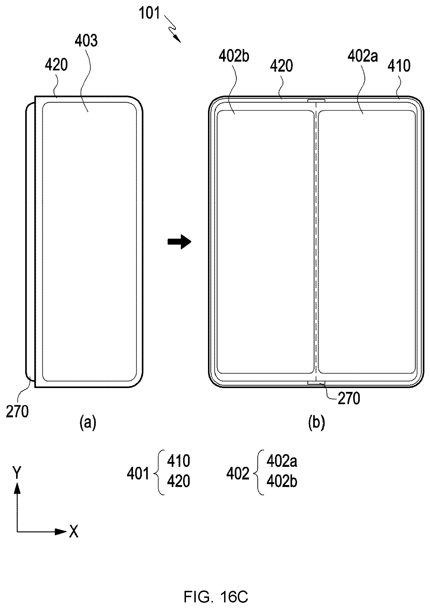

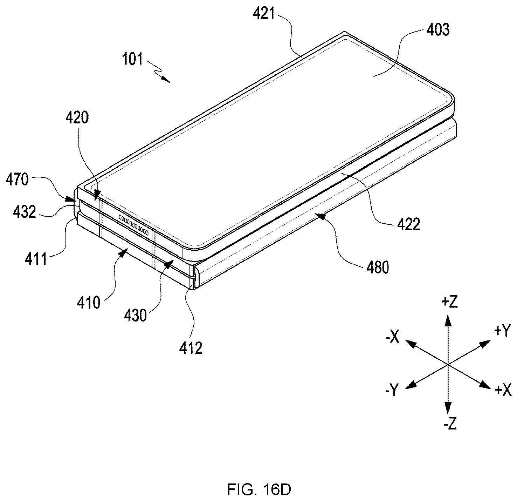

FIG. 16C is a perspective view of the electronic device in the folded state, according to an embodiment. FIG. 16D is a perspective view of the electronic device in the folded state, according to an embodiment. The components illustrated in FIGS. 16C and 16D may be partially or entirely the same as the components described with reference to FIGS. 1 to 4, 16A, and 16B.

Referring to FIG. 16C, the second housing 420 of the electronic device 101 according to an embodiment may be rotated relative to the first housing 410. The first hinge 470 may provide a rotation center for the second housing 420. Referring to FIG. 16D, the first hinge 470 may connect the (1-1)^{th} side portion 411 and the (2-1)^{th} side portion 421. The third housing 430 may be rotated relative to the first housing 410. The second hinge 480 may provide a rotation center for the third housing 430. The second hinge 480 may connect the (1-2)^{th} side portion 412 and the (3-1)^{th} side portion 431.

Referring to FIG. 16D, according to an embodiment, in the folded state, the first housing 410, the second housing 420, and the third housing 430 of the electronic device 101 may be stacked in one direction (e.g., the thickness direction or the Z-axis direction). For example, when the third housing 430 is rotated and folded relative to the first housing 410, the third housing 430 may be disposed above the first housing 410. When the second housing 420 is rotated and folded relative to the first housing 410, the second housing 420 may be disposed above the third housing 430. For example, in the folded state, the third housing 430 may be disposed between the first housing 410 and the second housing 420. According to an embodiment, the electronic device 101 may include a second display 403 disposed on the rear surface of the second housing 420. According to an embodiment, the electronic device 101 may include an input/output interface disposed on the rear surface of the third housing 430. Here, the rear surfaces (e.g., the second surface of the first housing, the fourth surface of the second housing, and the sixth surface of the third housing) may be configured to be oriented in the -Z direction when the electronic device 101 is in the unfolded state, as illustrated in FIGS. 16A and 16B. The rear surfaces may be configured to face away from the front surfaces (e.g., the first surface of the first housing, the third surface of the second housing, and the fifth surface of the third housing).

Referring to FIG. 16D, according to an embodiment, the housing 401 of the electronic device 101 may include the first housing 410 and the second housing 420. The electronic device 101 may include a hinge 470 disposed between the first housing 410 and the second housing 420. The second housing 420 may be rotated and folded or unfolded about the hinge 470 (e.g., about the Y-axis). The electronic device 101 may include a first display 402 disposed on the front surfaces (e.g., the first surfaces) of the first housing 410 and the second housing 420, and a second display 403 disposed on the rear surface (e.g., the second surface) of the second housing 420. The first display 402 may include a first display area 402a provided on the front surface (e.g., the first surface) of the first housing 410, and a second display area 402b provided on the front surface (e.g., the first surface) of the second housing 420.

Referring to FIG. 1 and FIGS. 16A to 16C, the electronic device 101 according to an embodiment may include a first display 402, a second display 403, memory 130, and at least one processor 120. In addition, the electronic device 101 may further include other components illustrated in FIG. 1. According to an embodiment, at least one processor 120 of the electronic device 101 may be operatively connected to the first display 402, the second display 403, and the memory 130, and may control the screen displayed on at least a portion of the first display 402 and/or the second display 403 when transitioning between a folded state and an unfolded state. The electronic device 101 according to an embodiment is not limited to folding in the direction illustrated in FIGS. 16A to 16D (e.g., about the Y-axis) but may be configured to be folded in another direction (e.g., about the X-axis).

When the housing 401 of the electronic device 101 according to an embodiment is configured to include the first housing 410 and the second housing 420, the second housing 420 may be rotated about the first hinge 470 to transition into the folded state. When the housing 401 of the electronic device 101 according to an embodiment is configured as a multi-foldable structure including the first housing 410, the second housing 420, and the third housing 430, as illustrated in FIG. 16D, the third housing 430 may be rotated about the second hinge 480 to transition into a folded state (e.g., a first folded state), and the second housing 420 may be rotated about the first hinge 470 to transition into a folded state (e.g., a second folded state).

According to an embodiment, at least one processor 120 may receive a first user input while the second housing 420 is in the folded state. When the second housing 420 transitions from the folded state to the unfolded state, the processor 120 may control the first display 402 to display a first screen on the first display 402. Here, the first screen may be displayed on the first display 402 while maintaining the screen displayed on the second display 403 in the folded state, and may include execution screens of at least two or more applications, including a first application. The first user input may be an input from a first button (e.g., a power button) disposed on the third surface (e.g., the (2-2)^{th} side portion 422) of the second housing 420. According to an embodiment, the at least one processor 120 may control the first display 402 to display a second screen on the first display 402 based on identifying that the first housing 410 is transitioned from the folded state to the unfolded state without the first user input while the second housing 420 is in the folded state. Here, the second screen may be a predetermined screen different from the screen displayed on the second display 403 and may include the execution screen of the first application aligned with the first display 402.

According to an embodiment, when identifying that the second housing 420 receives a touch input in the unfolded state and is transitioned from the unfolded state to the folded state, the at least one processor 120 may control the second display 403 to display the first screen displayed on one area of the first display 402 in the unfolded state by maintaining the first screen displayed on the second display 403. According to an embodiment, when identifying that the second housing 420 is transitioned from the unfolded state to the folded state without receiving a touch input while the second housing 220 is in the unfolded state, the at least one processor 120 may turn off the second display 403.

A typical foldable electronic device may include a flexible circuit board disposed to extend across a hinge assembly that connects both housings. In such a flexible circuit board, the bending area adjacent to the hinge assembly bends and unfolds during the folding operation of the foldable device. Due to repeated folding operations, damage such as cracks may occur during use. To reduce damage to the flexible circuit board and extend its lifespan, the length of the flexible circuit board needs be secured appropriately and the flexible circuit board needs to be properly shaped within the electronic device without tilting (i.e., the central position of the flexible circuit board needs to be maintained). For example, if the flexible circuit board is too short in length, it may be pulled by a structure attached to the housing when the electronic device is in the folded state, and there is a risk of tensile cracks occurring in the flexible circuit board. For example, if the flexible circuit board is too long in length, when the electronic device is in the unfolded state, the bending area of the flexible circuit board may be excessively bent (resulting in excessive deformation of the bending area increases), increasing the risk of cracks in the flexible circuit board. For example, if an abnormality occurs in the folding operation of the electronic device due to external force or other factors, the shaping of the flexible circuit board may deviate from the design position. In this case, for example, the flexible circuit board may be tilted toward one of the two housings, which may cause stress concentration in the tilted area, making it more susceptible to damage. If such damage accumulates, the lifespan of the flexible circuit board may be shortened.

One or more embodiments of the disclosure are intended to resolve at least the above-described issues and/or disadvantages and to provide at least the advantages described below. According to an embodiment of the disclosure, in a foldable electronic device, a center bar structure configured to support the bending area of a flexible circuit board may be provided, wherein the center bar structure is disposed around a hinge assembly. The center bar structure may include a structure in which a support member and a cover member are disposed on both sides of the bending area of the flexible circuit board. By including curved surfaces on the surfaces in contact with the flexible circuit board, the support member and the cover member may be configured to reduce the amount of deformation and stress when the flexible circuit board bends and unfolds according to the folding operation of the electronic device. The center bar structure according to an embodiment of the disclosure does not need to be attached to the housing of the electronic device, thereby improving the design flexibility of the length of the flexible circuit board, and allowing the length of the flexible circuit board to be configured to a length that minimizes crack occurrence. According to the center bar structure of an embodiment of the disclosure, the occurrence rate of cracks in the flexible circuit board may be reduced, and the lifespan of the flexible circuit board may be extended.

However, the problems that the disclosure seeks to solve are not limited to the aforementioned problems, and may be expanded in various ways without departing from the spirit and scope of the disclosure. The effects that may be obtained from the disclosure are not limited to the effects mentioned above, and various effects that are directly or indirectly identified through this document may be provided.

The center bar structure of the disclosure described above and the electronic device including the center bar structure are not limited to the foregoing embodiments and drawings, and it will be apparent to those skilled in the art to which the disclosure pertains that various substitutions, modifications, and changes can be made within the technical scope of the disclosure.

According to an embodiment of the disclosure, it is possible to provide an electronic device 101. The electronic device may include a housing 201 including a first housing 210, a second housing 220, and a hinge cover 230 or 330, a flexible display 240, 341, or 342 disposed on the housing, a hinge assembly 280 rotatably connected to the first housing and the second housing and including a first support structure 321 connected to the first housing and a second support structure 322 connected to the second housing, a center bar structure 303 disposed at least partially between the first support structure and the second support structure and spaced apart from the hinge cover, and a flexible printed circuit board 270 or 350 disposed in the housing. The center bar structure may include a support member 360 including a first seating portion recessed toward the hinge cover and a cover member 370 disposed to cover at least a portion of the support member. The flexible circuit board may include a first portion 352 disposed in the first housing, a second portion 353 disposed in the second housing, and a bending area 351 extending between the first portion and the second portion. At least a portion of the bending area may be disposed between the first seating portion and the cover member.

According to an embodiment, the first seating portion may include a convex surface which is convex toward the bending area.

According to an embodiment, the cover member may include a second seating portion 371 disposed to face the first seating portion with at least a portion of the bending area interposed therebetween. The second seating portion may include a concave surface which is concave toward the bending area.

According to an embodiment, the curvature of the concave surface may be similar to, the same as, or smaller than the curvature of the convex surface.

According to an embodiment, based on a width measured in a first direction intersecting a longitudinal direction of the flexible circuit board, the width d2 of the cover member may be greater than the width d1 of the first seating portion of the support member.

According to an embodiment, the cover member may include a first opening 377 and a second opening 378 at both ends disposed in a first direction intersecting the longitudinal direction of the flexible circuit board. The center bar structure may include fixing members 380 configured to fix the cover member to the support member, and the fixing members may include a first fixing member (381) passing through the first opening and a second fixing member (382) passing through the second opening.

According to an embodiment, the first fixing member and the second fixing member may be respectively fixed to both ends of the support member with the first seating portion of the support member interposed between the first fixing member and the second fixing member.

According to an embodiment, a portion 351a of the bending area may be disposed to pass between the first fixing member and the second fixing member.

According to an embodiment, the center bar structure may include a buffer member 390. The buffer member may further include at least one of a first buffer member 391 disposed between the first seating portion of the support member and at least a portion of the bending area and having a stiffness lower than that of the first seating portion, or a second buffer member 392 disposed between the cover member and at least a portion of the bending area and having a stiffness lower than that of the cover member.

According to an embodiment, based on a thickness measured in a radial direction of curvature of the bending area, the thickness t2 or t3 of the buffer member may be smaller than the thickness t1 of the bending area.

According to an embodiment, the support member and the cover member may be made of different materials.

According to an embodiment, the surface hardness of the support member is greater than that of the cover member.

According to an embodiment, the flexible circuit board may include a first flexible circuit board 350-1 and a second flexible circuit board 350-2.

According to an embodiment, the cover member may further include a first cover member (370-1) disposed on the first flexible circuit board and a second cover member (370-2) disposed on the second flexible circuit board.

According to an embodiment, the cover member may further include an additional opening formed between an area on which the first flexible circuit board is placed and an area on which the second flexible circuit board is placed.

The center bar structure may further include a fixing member configured to pass through the additional opening and secure the cover member to the support member.

According to an embodiment, the first seating portion may further include a 1-1 seating portion on which the first flexible circuit board is disposed, and a 1-2 seating portion spaced apart from the 1-1 seating portion and on which the second flexible circuit board is disposed.

According to an embodiment, the center bar structure may include a first center bar structure configured to support a portion of the first flexible circuit board, and a second center bar structure separated from the first center bar structure and configured to support a portion of the second flexible circuit board.

According to an embodiment of the disclosure, it is possible to provide an electronic device 101. The electronic device may include a housing 201 including a first housing 210, a second housing 220, and a hinge cover 230 or 330, a flexible display 240, 341, or 342 disposed on the housing, a hinge assembly 280 rotatably connected to the first housing and the second housing and including a first support structure 321 connected to the first housing and a second support structure 322 connected to the second housing, a center bar structure 303 disposed at least partially between the first support structure and the second support structure and spaced apart from the hinge cover, and a flexible printed circuit board 270 or 350 disposed in the housing. The center bar structure may include a support member 360 and a cover member 370. The flexible circuit board may include a first portion 352 disposed in the first housing, a second portion 353 disposed in the second housing, and a bending area 351 extending between the first portion and the second portion. At least a portion of the bending area may be disposed between the support member and the cover member.

According to an embodiment, the support member may include a first seating portion configured such that a portion of the bending area is disposed on the first seating portion, and the first seating portion may include a convex surface which is convex toward the bending area. The cover member may include a second seating portion 371 disposed to face the first seating portion with at least a portion of the bending area interposed between the first seating portion and the second seating portion, and the second seating portion may include a concave surface which is concave toward the bending area.

According to an embodiment, the cover member may include a first opening 377 and a second opening 378 at both ends disposed in a first direction intersecting the longitudinal direction of the flexible circuit board. The center bar structure may include fixing members 380 configured to fix the cover member to the support member, and the fixing members may include a first fixing member 381 passing through the first opening and a second fixing member 382 passing through the second opening.

Although the disclosure has been described with reference to an embodiment as an example, it is to be understood that the embodiment is intended to be exemplary and is not limiting the disclosure. It will be apparent to those skilled in the art that various changes in form and detail may be made without departing from the overall scope of the disclosure, including the appended claims and their equivalents.

The electronic device according to an embodiment may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that an embodiment of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with an embodiment of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{TM}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a housing comprising a first housing (210), a second housing (220), and a hinge cover (230; 330);
a flexible display (240,341,342) on the housing;
a hinge assembly (280) rotatably connected to the first housing and the second housing, wherein the hinge assembly comprises a first support structure (321) connected to the first housing and a second support structure (322) connected to the second housing;
a center bar structure (303) at least partially between the first support structure and the second support structure and spaced apart from the hinge cover, wherein the center bar structure comprises a support member (360) comprising a first seating portion recessed toward the hinge cover and a cover member (370) on at least a portion of the support member; and
a flexible circuit board (270; 350) in the housing, wherein the flexible circuit board comprises a first portion in the first housing, a second portion (353) in the second housing, and a bending area (351) extending between the first portion and the second portion, wherein at least a portion of the bending area is between the first seating portion of the support member and the cover member.

2. The electronic device of claim 1, wherein the first seating portion comprises a convex surface which is convex toward the bending area.

3. The electronic device of claim 2, wherein the cover member comprises a second seating portion (371) facing the first seating portion with at least a portion of the bending area interposed therebetween, the second seating portion comprising a concave surface which is concave toward the bending area.

4. The electronic device of claim 3, wherein a degree of curvature of the concave surface is similar to, the same as, or smaller than a degree of curvature of the convex surface.

5. The electronic device of any one of claims 1 to 4,
wherein a width (d2) of the cover member is greater than a width of the first seating portion of the support member, and
wherein each of the width of the cover member and the width of the first seating portion are measured in a first direction intersecting a longitudinal direction of the flexible circuit board.

6. The electronic device of any one of claims 1 to 5,
wherein the cover member comprises a first opening on a first end of the cover member and a second opening on a second end of the cover member, and
wherein the center bar structure comprises fixing members configured to fix the cover member to the support member, the fixing members comprising a first fixing member passing through the first opening and a second fixing member passing through the second opening.

7. The electronic device of claim 6, wherein the first fixing member and the second fixing member are respectively fixed to the first end and the second end of the support member with the first seating portion of the support member interposed between the first fixing member and the second fixing member.

8. The electronic device of claim 6 or 7, wherein a portion of the bending area passes between the first fixing member and the second fixing member.

9. The electronic device of any one of claims 1 to 8,
wherein the center bar structure further comprises a buffer member, and
wherein the buffer member comprises at least one of:
a first buffer member between the first seating portion and at least a portion of the bending area, the first buffer member having a hardness lower than a hardness of the first seating portion; or
a second buffer member between the cover member and the at least a portion of the bending area, the second buffer member having a hardness lower than a hardness of the cover member.

10. The electronic device of claim 9,
wherein a thickness of the buffer member is smaller than a thickness of the bending area, and
wherein the thickness of the buffer member and the thickness of the bending area are measured in a radial direction of a curvature of the bending area.

11. The electronic device of any one of claims 1 to 10, wherein the flexible circuit board comprises a first flexible circuit board and a second flexible circuit board.

12. The electronic device of claim 11, wherein the cover member further comprises a first cover member on the first flexible circuit board and a second cover member on the second flexible circuit board.

13. The electronic device of claim 11 or 12,
wherein the cover member further comprises an additional opening formed between an area on which the first flexible circuit board is placed and an area on which the second flexible circuit board is placed, and
wherein the center bar structure further comprises a fixing member configured to pass through the additional opening and fix the cover member to the support member.

14. The electronic device of any one of claims 11 to 13, wherein the first seating portion comprises a 1-1 seating portion on which the first flexible circuit board is disposed, and a 1-2 seating portion spaced apart from the 1-1 seating portion and on which the second flexible circuit board is disposed.

15. The electronic device of any one of claims 11 to 14, wherein the center bar structure comprises a first center bar structure configured to support a portion of the first flexible circuitboard, and a second center bar structure separated from the first center bar structure and configured to support a portion of the second flexible circuit board.
